# EUROPEAN PATENT APPLICATION

(11) **EP 1 739 846 A2**
(43) Date of publication of application: **03.01.2007**
(21) Application number: 06010288.6
(22) Date of filing: 18.05.2006
(51) Int. Cl.: H04B 1/38, H04B 15/06

(54) **Signal generating apparatus, IC chip, GPS receiver, and cellular phone**

(30) Priority: 28.06.2005 JP 2005188333
(71) Applicant: SEIKO EPSON CORPORATION, Shinjuku-ku, Tokyo 163-0811 (JP)
(72) Inventor: Hatanaka, Koichi, Suwa-shi Nagano-ken 392-8502 (JP)
(74) Representative: HOFFMANN EITLE

(57) **Abstract**

A composition purpose signal generating apparatus, which includes an oscillator (11) for outputting a composition purpose signal, a frequency divider (12a,12b) for dividing the frequency of the composition purpose signal, a reference oscillator (9) for outputting a reference signal, a phase comparator (13) for outputting phase difference data which indicates a phase difference between the composition purpose signal and the reference signal, and a filter (14) for outputting the phase difference data output from the phase comparator as a control voltage of the oscillator, comprises composition purpose signal frequency changing means (15) for changing the frequency of the composition purpose signal when the frequency of a composite wave consisting of a basic wave or harmonic constituting a communication signal, which is an interference wave to the receiving signal, and a basic wave or harmonic constituting the composition purpose signal is almost equal to the frequency of the intermediate frequency signal.

## Description

This application claims the priorities benefit under 35 U.S.C.§ 119 of Japanese Patent Application No.2005-188333 filed on Jun 28, 2005, which is hereby incorporated in its entirety by reference.

### BACKGROUND

### 1. Technical Field

The present invention relates to a receiver which receives signals for positioning.

### 2. Related Art

Conventionally, GPS (Global Positioning System) receivers have been mounted on communicating devices such as cellular phones and PDAs (Personal Digital Assistants). However, if such GPS receiver and cellular phone are used simultaneously, a communication signal transmitted from the cellular phone or the like may be an interference wave to GPS signals to be received by the GPS receiver.

Therefore, conventional GPS receivers have allowed simultaneous use of a GPS receiver and a cellular phone or a PDA by eliminating a communication signal transmitted from the cellular phone or the like from a receiving signal using a SAW (SurfaceAcoustic Wave)filter(e.g.,JP-A-2003-255036[0043]).

However, filters such as the SAW filter and the like allow elimination of communication signals which are interference waves, but causes decrease in the S/N ratio (Signal to Noise ratio) of several dBm of GPS signals. Accordingly, there is a problem that the above-mentioned conventional GPS receivers may not obtain high sensitivity in terms of GPS signals when the GPS receiver and a cellular phone or the like are being used simultaneously.

### SUMMARY

Therefore, an advantage of some aspects of the invention is to provide a composition purpose signal generating apparatus, an IC (Integrated Circuit) chip, a GPS receiver, and a cellular phone, which allow obtainment of high sensitivity in terms of receiving signals without being affected by interference waves without using a filter such as a SAW filter or the like, when reception/ transmission of communication signals and reception of positioning signals are carried out simultaneously.

In order to achieve the above object, a composition purpose signal generating apparatus according to a first aspect of the invention, which includes an oscillator for outputting a composition purpose signal to a frequency changing apparatus which outputs a composite wave consisting of a receiving signal and the composition purpose signal as an intermediate frequency signal, a frequency divider for dividing the frequency of the composition purpose signal output from the oscillator, a reference oscillator for outputting a reference signal, a phase comparator for outputting phase difference data which indicates a phase difference between the composition purpose signal which is frequency divided by the frequency divider and the reference signal, and a filter for outputting the phase difference data output from the phase comparator as a control voltage of the oscillator, includes composition purpose signal frequency changing means for changing the frequency of the composition purpose signal when the frequency of a composite wave consisting of a basic wave or harmonic constituting a communication signal which is interference wave to the receiving signal and a basic wave or harmonic constituting the composition purpose signal is almost equal to the frequency of the intermediate frequency signal.

In the frequency changing apparatus, the receiving signal and the composition purpose signal are compounded as well as a basic wave or harmonic constituting a communication signal which is an interference wave to the receiving signal and a basic wave or harmonic constituting the composition purpose signal are compounded. Accordingly, even if the frequency of the communication signal is different from that of the receiving signal, the frequency of the composite wave consisting of a basic wave or harmonic constituting the communication signal and a basic wave or harmonic constituting the composition purpose signal may be almost equal to the frequency of the intermediate frequency signal. In this case, the intermediate frequency signal which is a composite wave consisting of the receiving signal and the composition purpose signal and a composite wave consisting of the communication signal and the composition purpose signal cannot be identified, resulting in decrease in the sensitivity of the receiver.

At this point, with the structure according to the first aspect of the invention, the composition purpose signal generating apparatus can change the frequency of the composition purpose signal using the composition purpose signal frequency changing means when the frequency of the composite wave consisting of a basic wave or harmonic constituting the communication signal which is an interference wave to the receiving signal and a basic wave or harmonic constituting the composition purpose signal is almost equal to the frequency of the intermediate frequency signal.

This prevents the frequency of the composite wave consisting of the communication signal and the composition purpose signal from being almost equal to the frequency of the intermediate frequency signal.

This allows obtainment of high sensitivity in terms of the receiving signal without being affected by the interference wave to the receiving signal without using a filter such as a SAW filter or the like when transmission of communication signal and reception of positioning signal are carried out simultaneously.

It should be noted that 'almost equal' in this specification means a case of being strictly equal as well as a case of not being strictly equal.

A second aspect of the invention is a composition purpose signal generating apparatus with a structure according to the first aspect of the invention, includes a plurality of frequency dividers with different frequency dividing ratios, wherein the composition purpose signal changing means changes the frequency of the composition purpose signal by switching the frequency divider to another one with different frequency dividing ratio.

With the structure according to the second aspect of the invention, the composition purpose signal frequency changing means switches the frequency divider to another one with different frequency dividing ratio. The control voltage generated by the phase comparator can be switched by switching the frequency divider, allowing switching of the frequency of the composition purpose signal output from the oscillator.

A third aspect of the invention is a composition purpose signal generating apparatus with a structure according to the first aspect of the invention, includes a.plurality of reference oscillators which outputs different frequencies, wherein the composition purpose signal changing means changes the frequency of the composition purpose signal by switching the reference oscillator to another one which outputs different frequency.

With the structure according to the third aspect of the invention, the composition purpose signal frequency changing means switches the reference oscillator to another one which outputs different frequency. The control voltage generated by the phase comparator can be switched by switching the reference oscillator, allowing switching of the frequency of the composition purpose signal output from the oscillator.

In order to achieve the above object, an IC chip according to a fourth aspect of the invention includes the composition purpose signal generating apparatus according to any of the first through the third aspect of the invention.

For example, since a SAW filter must be externally loaded to the IC chip to eliminate interference wave using the SAW filter, it is difficult to reduce the size of a receiver.

At this point, with the structure according to the fourth aspect of the invention, the IC chip can suppress the influence of the interference wave without using the SAW filter, allowing reduction in the size of the receiver.

In order to achieve the above object, a GPS receiver according to a fifth aspect of the invention includes the IC chip according to fourth aspect of the invention.

With the structure according to the fifth aspect of the invention, it is possible to reduce weight, increase operation speed, and decrease cost of the GPS receiver.

In order to achieve the above object, a cellular phone according to a sixth aspect of the invention includes the IC chip according to fourth aspect of the invention.

With the structure according to the sixth aspect of the invention, it is possible to position using a receiving signal while a telephone conversation.

### BRIEF DESCRIPTION OF THE DRAWINGS

The invention will be described with reference to the accompanying drawings, wherein like numbers reference like elements.

Fig. 1 shows a GPS locator-equipped cellular phone in an embodiment according to the invention.

Fig. 2 shows an example of GPS signal and the like.

Fig. 3 shows an exemplary structure of a PLL device.

Fig. 4 shows a flowchart of an operation example of the GPS locator-equipped cellular phone 1.

Fig. 5 shows a flowchart of an operation example of the GPS locator-equipped cellular phone 1.

Fig. 6 shows an exemplary structure of a PLL device.

### DESCRIPTION OF EXEMPLARY EMBODIMENTS

Hereinafter, with reference to the drawings, the preferred exemplary embodiments of the invention will be described in detail.

### First Embodiment

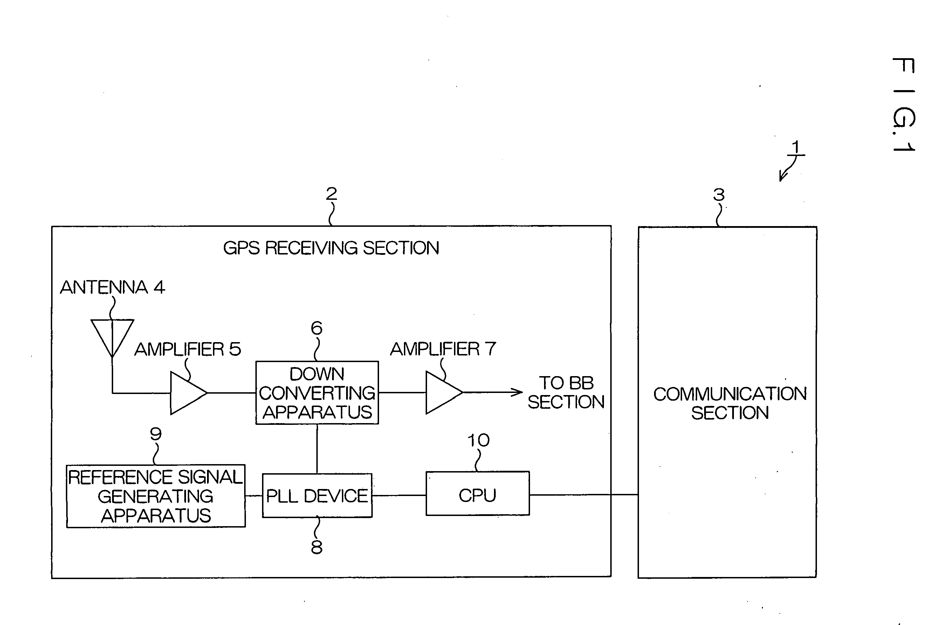

Fig. 1 schematically illustrates a GPS locator-equipped cellular phone 1 according to a first embodiment of the invention.

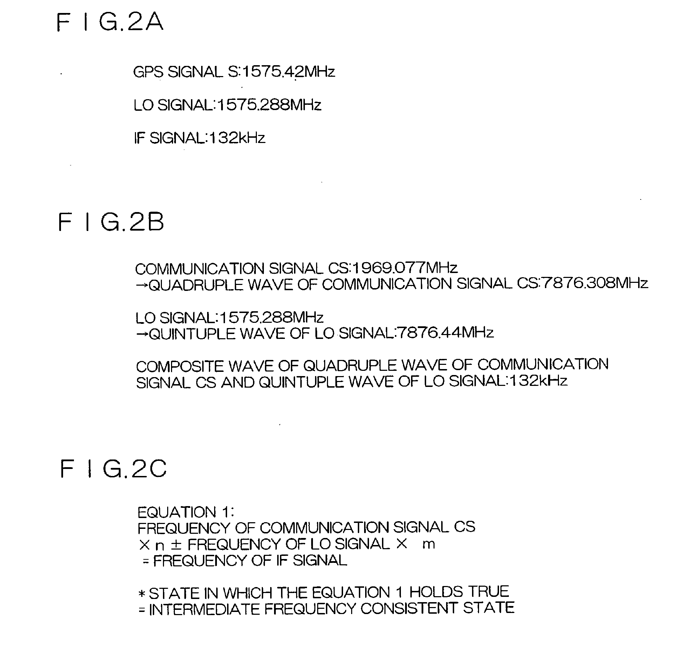

As illustrated in Fig. 1, the GPS locator-equipped cellular phone 1 includes a GPS receiving section 2 for receiving a GPS signal S (see Fig. 2 A), and a communication section 3 for receiving/ transmitting a communication signal CS (see Fig. 2 B). The GPS signal S is an example of receiving signals. In this embodiment, the communication signal CS is an interference wave to the GPS signal S, to be described later.

In addition, as illustrated in Fig. 1, the GPS locator-equipped cellular phone 1 includes the GPS receiving section 2. The GPS receiving section 2 includes a CPU 10 for controlling each section, an antenna 4 for receiving the GPS signal, and the like.

The GPS receiving section 2 also includes a reference signal generating apparatus 9 for outputting a reference signal. The reference signal generating apparatus 9 may be a crystal oscillator, for example, which can stably generate predetermined frequencies. The reference signal generating apparatus 9 is an example of reference oscillators.

The GPS receiving section 2 also includes amplifiers 5 and 7, a down converting apparatus 6, and a PLL (Phase Locked Loop) device 8.

The down converting apparatus 6 outputs a composite wave consisting of the GPS signal S received by the antenna 4 and input through the amplifier 5 and the LO signal output from the PLL device 8 as an IF (Intermediate Frequency) signal. The LO signal is an example of composition purpose signals. The PLL device 8, the reference signal generating apparatus 9, and the CPU 10 are an example of the composition purpose signal generating apparatus. The IF signal is an example of the intermediate frequency signals. The down converting apparatus 6 is an example of frequency converting apparatus.

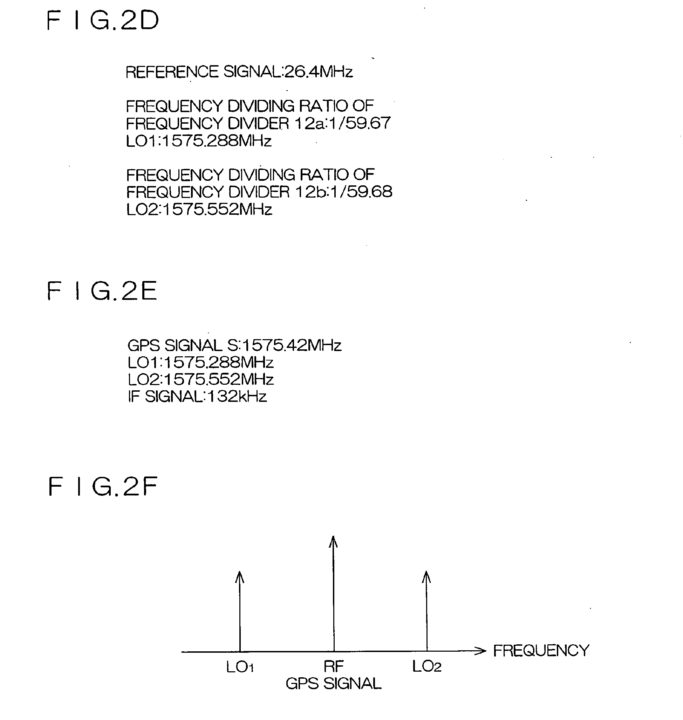

Fig. 2 illustrates an example of frequencies and the like of the GPS signal S to be received by the antenna 4.

As illustrated in Fig. 2 A, the GPS signal S of 1575.42 MHz and the LO signal of 1575.288 MHz are multiplied on a circuit basis in the down converting apparatus 6 (see Fig. 1), generating the IF signal of 132 kHz.

On the other hand, as illustrated in Fig. 2 B, assuming that the communication signal CS is that of 1969.077 MHz, the frequency of quadruple wave thereof is 7876.308 MHz. In addition, the frequency of quintuple wave of the LO signal of 1575.288 MHz is 7876.44 MHz. The quadruple wave of the communication signal CS and the quintuple wave of the LO signal are multiplied on a circuit basis in the down converting apparatus 6, generating a signal of 132 kHz. In this case, the communication signal CS is an interference wave to the GPS signal S.

At this point, the following structure of the GPS locator-equipped cellular phone 1 can prevent the communication signal CS from being an interference wave to the GPS signal S.

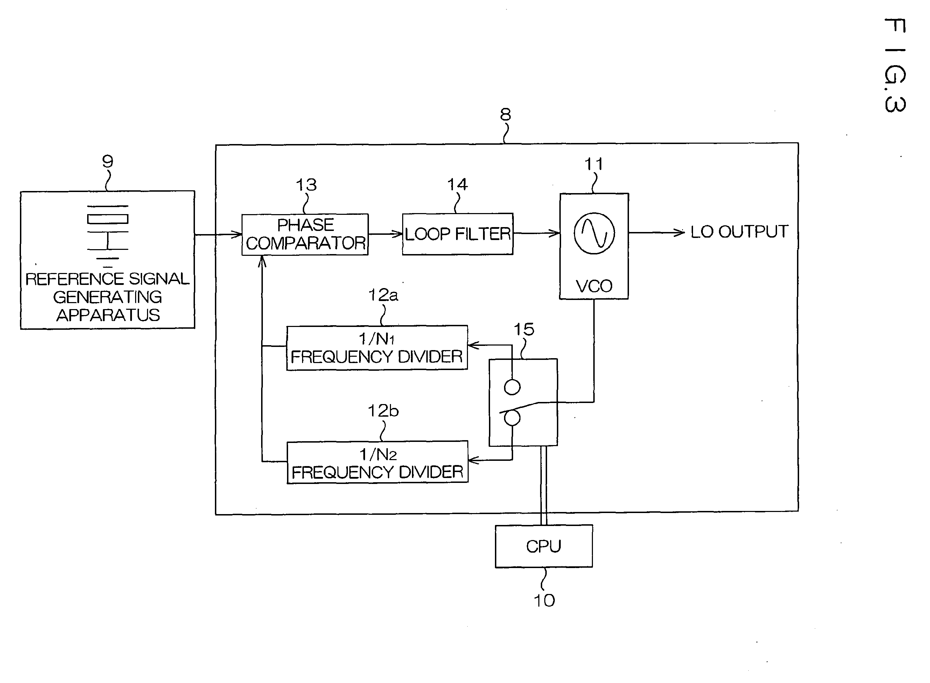

Fig. 3 schematically illustrates an example of a structure of the PLL device 8 and the like.

As illustrated in Fig. 3, the PLL device 8 includes a VCO (Voltage Controlled Oscillator) 11. The VCO 11 outputs LO signals. In other words, the VCO 11 is an example of oscillators.

In addition, the PLL device 8 includes two frequency dividers 12a and 12b. The frequency dividers 12a and the like divide the frequencies of the LO signals output from the VCO 11. The frequency dividers 12a and the like are an example of frequency dividers.

The PLL device 8 also includes a phase comparator 13. The phase comparator 13 receives the LO signals which are frequency divided by the frequency divider 12a or 12b and the reference signal from the reference signal generating apparatus 9, and outputs phase difference data which indicates phase difference between the received LO signals and the reference signal to a loop filter 14.

The loop filter 14 eliminates an alternate current component from the received phase difference data, and outputs the resulting data as control voltage to the VCO 11.

As mentioned above, the VCO 11 is controlled by the control voltage from the loop filter 14, allowing the PLL device 8 to stably output the LO signals at the desired frequency.

It should be noted that the PLL device 8 is a frequency-based negative feedback circuit, allowing the VCO 11 to continuously operate at the stable frequency. The stable frequency is that determined based on the frequency of the reference signal and the frequency dividing ratio of the frequency divider.

The PLL device 8 also includes a switch 15. The LO signals output from the VCO 11 are input to the down converting apparatus 6 as well as to either of two frequency dividers 12a and 12b with different frequency dividing ratios, and are frequency divided. In other words, the free-running frequency of the VCO 11 in the PLL device 8 is higher than an oscillation frequency generated by the reference signal generating apparatus 9 such as a crystal oscillator. Accordingly, the PLL device 8 decreases the frequency of the LO signal down to that equivalent to that of the reference signal using the frequency dividers 12a and 12b, and inputs the resulting signal to the phase comparator 13.

The PLL device 8 determines either of two frequency dividers 12a and 12b to which the LO signal is input by switching the switch 15. More specifically, the switch 15 is controlled by the CPU 10.

The CPU 10 changes the frequency of the LO signal by controlling the switch 15 to switch the frequency dividers 12a and 12b when the communication signal CS is an interference wave to the GPS signal S. In other words, the CPU 10 and the switch 15 are an example of composition purpose signal frequency changing means.

The frequency of the LO signal is determined based on the frequency of the reference signal output from the reference signal generating apparatus 9 and the frequency dividing ratio of the frequency divider 12a or the like. The CPU 10 switches the frequency dividers 12a and 12b when equation 1 in Fig. 2 C holds true.

In other words, the frequency dividers 12a and 12b are switched when the frequency of the composite wave consisting of either basic wave or harmonic constituting the communication signal CS and either basic wave or harmonic constituting the LO signal is equal to the frequency of the IF signal (hereinafter, referred to as intermediate frequency consistent state).

This prevents the equation 1 from holding true. In other words, this prevents from entering the intermediate frequency consistent state.

It should be noted that the equation 1 indicates the strict intermediate frequency consistent state, however, the frequency dividers 12a and 12b are switched in the strict intermediate frequency consistent state as well as when the frequency of the composite wave consisting of either basic wave or harmonic constituting the communication signal CS and either basic wave or harmonic constituting the LO signal is almost equal to the frequency of the IF signal. In other words, the CPU 10 switches the frequency dividers 12a and 12b when difference between the frequency of the communication signal CS down converted by the down converting apparatus 6 (see Fig. 1) and the frequency of the IF signal falls within the range of frequency at which the communication signal S is an interference wave to the GPS signal S, for example, 5 percents (%).

As illustrated in Fig. 2 D, the frequency of the reference signal is 26.4 MHz, the frequency dividing ratio of the frequency divider 12a is 1/59. 67, and the frequency dividing ratio of the frequency divider 12b is 1/59.68.

When using the frequency divider 12a, LO1 is generated, and a composite wave consisting of quintuple wave of the LO1 and quadruple wave of the communication signal CS of 1969.077 MHz causes the intermediate frequency consistent state.

However, when using the frequency divider 12b, LO2 of the frequency of 1575.552 MHz is generated, and a composite wave consisting of a basic wave or harmonic of the LO2 and a basic wave or harmonic of the communication signal CS does not cause the intermediate frequency consistent state.

Accordingly, as illustrated in Fig. 2 B, when the frequency of the communication signal CS is 1969.077 MHz, the CPU 10 controls the switch 15 to use the frequency divider 12b, preventing from causing the intermediate frequency consistent state.

On the other hand, as illustrated in Fig. 2 E, the frequency of the GPS signal S equals to that of the IF signal whichever it is compounded with the LO1 or the L02. In other words, as illustrated in Fig. 2 F, the difference between the frequency of the GPS signal S and the frequency of the LO1 and the LO2 is equal to the IF frequency, the frequency of the GPS signal S equals to the frequency of the IF signal whichever it is compounded with the LO1 or the L02.

This allows obtainment of high sensitivity in terms of the receiving signal without using a filter such as a SAW filter or the like when transmission of communication signals and reception of positioning signals are carried out simultaneously.

The structure of the GPS locator-equipped cellular phone 1 is described above. Hereinafter, an operation example of the GPS locator-equipped cellular phone 1, particularly, a method of determining whether or not the intermediate frequency consistent state is established is described: It should be noted that establishment of the intermediate frequency consistent state is referred to as satisfaction of a switching condition.

### Operation Example of GPS Locator-Equipped Cellular Phone 1

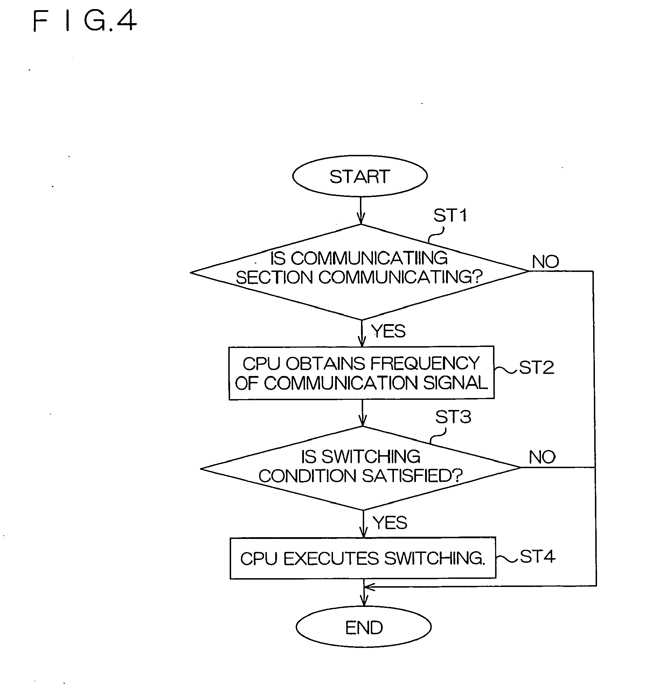

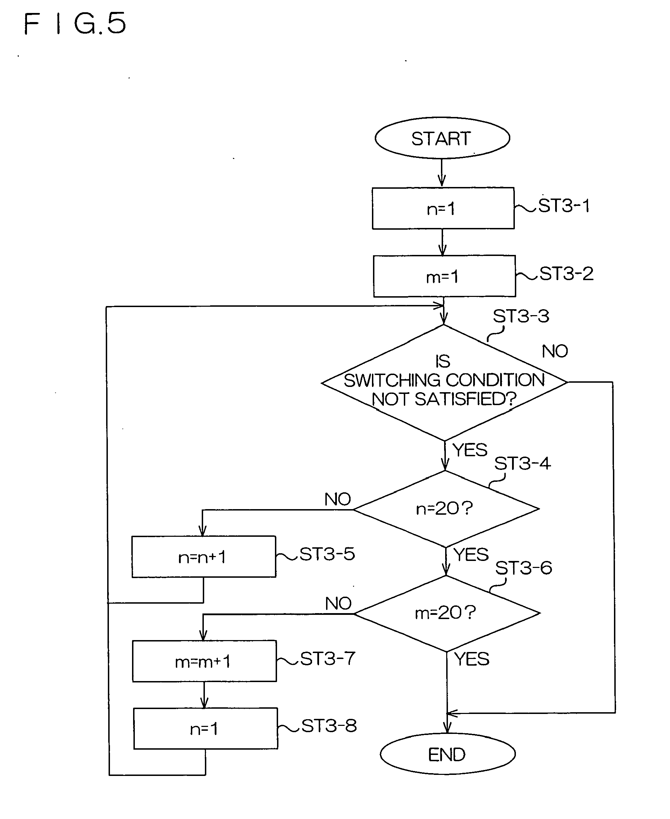

Figs. 4 and 5 schematically illustrate flowcharts of an operation example of the GPS locator-equipped cellular phone 1.

First, the CPU 10 determines whether or not the communication section 3 is communicating (step ST1 in Fig. 5). If YES, it proceeds to step ST2.

In step ST2, the CPU 10 obtains the frequency of the communication signal CS.

It should be noted that the CPU 10 can obtain the frequency of the communication signal CS in real time or for every predetermined time from the communicating section 3 (see Fig. 1), however, if the frequency of the communication signal CS is fixed, it is enough that it is obtained from memory (not shown in the drawing) only once.

Next, the CPU 10 determines whether or not the equation 1 in Fig. 2 C holds true to determine whether or not the switching condition is satisfied (step ST3). When the CPU 10 determines that the switching condition is satisfied, the CPU 10 controls the switch 15 to switch the frequency dividers 12a and 12b. In other words, the CPU 10 controls the switch to switch the frequency dividers 12a and 12b when the frequency of a composite wave consisting of either basic wave or harmonic constituting the communication signal CS and either basic wave or harmonic constituting the LO signal is equal to the frequency of the IF signal.

Fig. 5 illustrates an example of a method of determining whether or not the switching condition is satisfied.

First, the CPU 10 initializes 'n' and 'm' shown in the equation 1 in Fig. 2 C (steps ST3-1, ST3-2). In other words, the CPU 10 sets 'n' and 'm' to '1', respectively.

Next, the CPU 10 determines whether or not the switching condition is satisfied (step ST3-3). If YES, it ends the process. Otherwise, it proceeds to the subsequent step (step ST3-4).

The CPU 10 then determines whether or not 'n = 20' holds true (step ST3-4). If NO, it sets 'n = n + 1' to increase 'n' by '1' (step ST3-5), and then returns to the step ST3-3. On the other hand, if the CPU 10 determines that 'n = 20' holds true, it proceeds to step ST3-6.

Afterwards, the CPU 10 determines whether or not 'm = 20' holds true (step ST3-4). If NO, it sets 'm = m + 1' to increase 'm' by '1' (step ST3-7), and sets 'n = 1' to set 'n' to '1' (step ST3-8), and then returns to the step ST3-3. On the other hand, if the CPU 10 determines that 'm = 20' holds true, it ends the process.

The above-mentioned method allows absolute determination of whether or not the equation 1 in Fig. 2 C holds true.

As mentioned above, the GPS locator-equipped cellular phone 1 allows suppression of influence of an interference wave without using a filter such as a SAW filter or the like, allowing obtainment of higher sensitivity in terms of the GPS signal than the conventional case even though the GPS locator function is used during a telephone conversation or during an e-mail transmission. For example, a SAW filter decreases the sensitivity in terms of the receiving signal by 1 to 2 dBm, however, the GPS locator-equipped cellular phone 1 allows suppression of influence of an interference wave without using the SAW filter, allowing prevention of the sensitivity in terms of the receiving signal from decreasing by 1 to 2 dBm.

In addition, the GPS locator-equipped cellular phone 1 allows positioning using the GPS signal S during a telephone conversation. Moreover, the PLL device 8 can be formed on an IC chip, allowing decrease in size of the GPS receiving section 2.

Moreover, the GPS locator-equipped cellular phone 1 allows provision of a down converting circuit capable of maintaining high sensitivity by preventing electronic waves which are interference waves.

Furthermore, the GPS locator-equipped cellular phone 1 has the following advantages in comparison with the case of externally attaching a filter such as a SAW filter or the like to the IC. First, there is no decrease in the sensitivity in terms of the GPS signal S due to the SAW filter, and the S/N ratio of the GPS signal S is improved. In addition, in the case of a structure with a frequency divider, circuits are incorporated in the IC chip, allowing reduction in the number of components attached to the IC externally, and reduction in the floor area.

### Second Embodiment

Next, a GPS locator-equipped cellular phone 1A according to a second embodiment of the invention is described.

Many parts of the structure of the GPS locator-equipped cellular phone 1A in the second embodiment are the same as those of the GPS locator-equipped cellular phone 1 according to the first embodiment described above, the same reference numerals are used for the same parts, and description thereof is thus omitted. Hereinafter, the differences are mainly described.

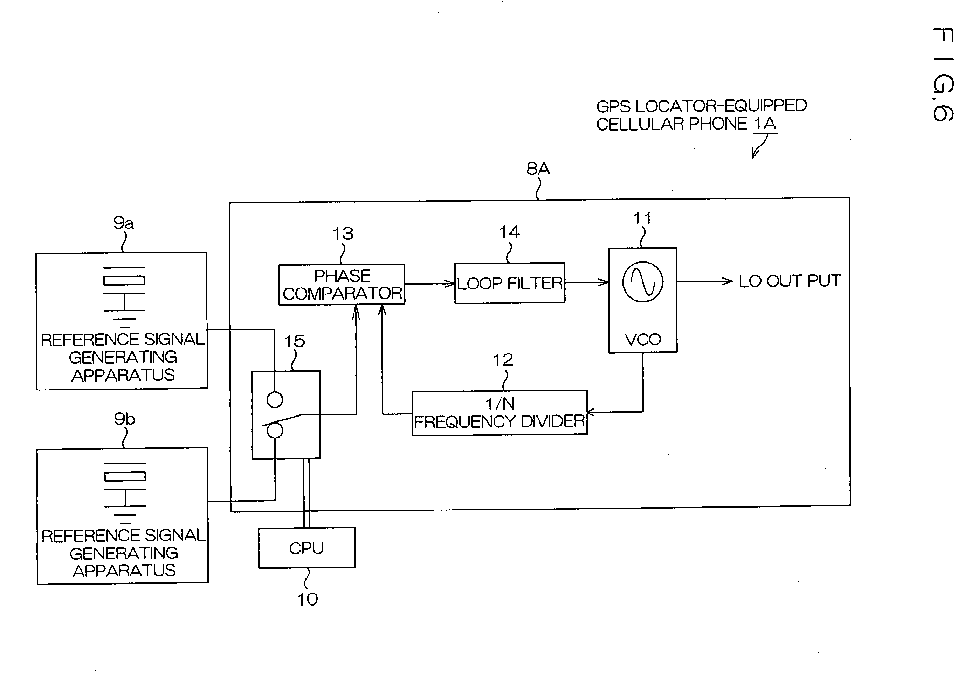

Fig. 6 schematically illustrates an example of a structure of a PLL device 8A which is a main section of the GPS locator-equipped cellular phone 1A.

As illustrated in Fig. 6, the PLL device 8A includes two reference signal generating apparatuses 9a and 9b.

Respective reference signals output from the reference signal generating apparatuses 9a and 9b have different frequencies from each other.

A switch 15 is controlled by a CPU 10. When the equation 1 in Fig. 2 C holds true, the CPU 10 controls the switch 15 to switch the reference signal generating apparatuses 9a and 9b. The CPU 10 and the switch 15 are an example of the composition purpose signal frequency changing means.

Switching the reference signal generating apparatuses 9a and 9b by the switch 15 allows switching of the frequency of the reference signal to be input to a phase comparator 13. This allows change in phase difference data to be output from the phase comparator 13, changing control voltage to be output to a VCO oscillator 11, and allowing switching of the frequency of the LO signal to be output from the VCO 11.

This prevents the equation 1 in Fig. 2 C from holding true, preventing the communication signal CS from being an interference wave to the GPS signal S.

The present invention is not limited to the above-described respective embodiments. Further, the above-described respective embodiments may be combined with each other.

For example, in the first embodiment, two frequency dividers 12a and 12b are provided, however, the PLL device 8 may include three or more of frequency dividers with different frequency dividing ratios.

In addition, in the second embodiment, two reference signal generating apparatuses 9a and 9b are provided, however, the PLL device 8A may include three or more of reference signal generating apparatuses with different frequencies.

For example, the GPS locator-equipped cellular phone 1 and the like receive the GPS signal S independently of the communication signal CS, however, the invention can be applied to the GPS signal S as well as to all receiving signals to be received independently of the communication signal CS.

In addition, the GPS locator-equipped cellular phone 1 and the like are described above, but not limited to this, the invention can be applied to all apparatuses having a receiver for receiving receiving signals such as the GPS signal S independently of reception/ transmission of the communication signal CS (e.g., RF (IC) section used for Bluetooth (R)).

Moreover, in the above-mentioned embodiments, the down converting apparatus 6 carries out frequency conversion for the received GPS signals, but not limited to this, the invention can use all frequency converting means capable of carrying out frequency conversion for receiving signals.

Furthermore, in the above-mentioned embodiment, the LO signal is output from the down converting apparatus 6, but not limited to this, the invention can use the LO signal as well as all composition purpose signals to be compounded with receiving signals for frequency conversion.

In addition, in the above-mentioned embodiment, the PLL device 8 is used for generating composition purpose signals such as LO signal, but not limited to this, the invention can use the PLL device 8 as well as all composition purpose generating apparatuses for generating composition purpose signals.

Moreover, as shown in the above-mentioned embodiments, if determination whether or not the switching condition shown in the equation 1 with the upper limit of 'n' and 'm' of 20 is satisfied is carried out for a basic wave to 20-time wave of the communication signal and for a basic wave to 20-time wave of the LO signal, the load on the CPU 10 can be suppressed, and the influence of the interference wave to the IF signal can be almost suppressed. However, the invention does not limit the harmonic for this determination up to 20 time wave. In the invention, the values of 'n' and 'm' may be natural numbers.

Furthermore, whether or not the equation 1 in Fig. 2 C holds true can be absolutely determined based on the method shown in Fig. 5, however, the invention does not limit the method of determining whether or not the switching condition shown in the equation 1 is satisfied. Accordingly, in the invention, any methods other than the method shown in Fig. 5 can determine whether or not the switching condition shown in the equation 1 is satisfied.

In addition, in the above-mentioned embodiments, the frequency of the LO signal is changed by switching the frequency dividers 12a and 12b or the reference signal generating apparatuses 9a and 9b using the switch, however, the invention includes all means for changing the frequency of composition purpose signals. For example, the invention includes changing of the frequency of the LO signal by switching both of the frequency dividers 12a and 12b and the reference signal generating apparatuses 9a and 9b.

## Claims

1. A composition purpose signal generating apparatus, which comprises an oscillator for outputting a composition purpose signal to a frequency changing apparatus which outputs a composite wave consisting of a receiving signal and the composition purpose signal as an intermediate frequency signal, a frequency divider for dividing the frequency of the composition purpose signal output from the oscillator, a reference oscillator for outputting a reference signal, a phase comparator for outputting phase difference data which indicates a phase difference between the composition purpose signal which is frequency divided by the frequency divider and the reference signal, and a filter for outputting the phase difference data output from the phase comparator as a control voltage of the oscillator, comprising
composition purpose signal frequency changing means for changing the frequency of the composition purpose signal when the frequency of a composite wave consisting of a basic wave or harmonic constituting a communication signal, which is an interference wave to the receiving signal, and a basic wave or harmonic constituting the composition purpose signal is almost equal to the frequency of the intermediate frequency signal.

2. The composition purpose signal generating apparatus according to claim 1, comprising
a plurality of frequency dividers with different frequency dividing ratios, wherein
the composition purpose signal frequency changing means changes the frequency of the composition purpose signal by switching the frequency divider to another one with different frequency dividing ratio.

3. The composition purpose signal generating apparatus according to claim 1, comprising
a plurality of reference oscillators which outputs different frequencies, wherein
the composition purpose signal frequency changing means changes the frequency of the composition purpose signal by switching the reference oscillator to another one which outputs different frequency.

4. An IC chip comprising the composition purpose signal generating apparatus according to any of claims 1 through 3.

5. A GPS receiver comprising the IC chip according to claim 4.

6. A cellular phone comprising the IC chip according to claim 4.
